# EUROPEAN PATENT SPECIFICATION

(11) **EP 2 761 049 B1**
(45) Date of publication and mention of the grant of the patent: **26.02.2020**
(21) Application number: 12766852.3
(22) Date of filing: 24.09.2012
(51) Int. Cl.: C23C 14/00, H01J 37/34, C23C 14/08, C23C 14/10, C23C 14/54

(54) **PROCESS OF COATING A SUBSTRATE WITH A THIN FILM OF METAL OR SEMICONDUCTOR COMPOUND**
VERFAHREN ZUR BESCHICHTUNG EINES SUBSTRATS MIT EINEM DÜNNFILM AUS EINER METALL- ODER HALBLEITERVERBINDUNG
PROCÉDÉ DE REVÊTEMENT D'UN SUBSTRAT PAR UNE COUCHE MINCE D'UNE COMPOSITION DE MÉTAL OU DE SEMI-CONDUCTEUR

(30) Priority: 26.09.2011 CH 15772011
(43) Date of publication of application: 06.08.2014
(73) Proprietor: Evatec AG, 8890 Flums (CH)
(72) Inventor: BIEDERMANN, Patrick, 9491 Ruggell (LI); PADRUN, Marco, 7304 Maidenfeld (CH); WALDNER, Stefan, 7320 Sargans (CH); SCHWYN THÖNY, Silvia, 7323 Wangs (CH)
(74) Representative: Troesch Scheidegger Werner AG
(86) International application number: PCT/CH2012/000219
(87) International publication number: WO 2013/044402

(56) References cited:
- EP-A2- 0 328 257
- US-A- 5 989 397
- KÖCKERT C ET AL: "Inline sputter systems versus cluster or batch tools - Sputter coaters for optical multilayers", OPTICAL INTERFERENCE COATINGS (OIC) JUNE 27, 2004, TUCSON, AZ [US], vol. ME2, 27 June 2004 (2004-06-27), pages 1-3, XP055013836, Optical Society of America, Washington, DC [US]
- GIBSON D R ET AL: "Deposition of multilayer optical coatings using closed-field magnetron sputtering", PROCEEDINGS OF SPIE, vol. 6286, 13 August 2006 (2006-08-13), page 628601-1, XP055013813, Society of Photographic Instrumentation Engineers (SPIE) [US] ISSN: 0277-786X, DOI: 10.1117/12.679052
- LIST M ET AL: "On-line control of the deposition of optical coatings by magnetron sputtering", OPTICAL INTERFERENCE COATINGS (OIC) TUCSON, AZ [US] JUNE 27, 2004 MONITORING (TUE), vol. TuE7, 27 June 2004 (2004-06-27), pages 1-3, XP055013806, Optical Society of America, Washington, DC [US]

## Description

### Field of the invention:

The invention relates to an improved process of forming thin films of a metal or semiconductor compound on a substrate through sputtering. The products obtained from the process are characterized by enhanced smoothness, reduced light scattering losses as well as high thresholds for laser damage.

### Background of the invention:

There are a number of different methods known in the art for coating objects (substrates) with a thin film of metal or metal compound. One such method is sputtering, a process whereby atoms in a solid target material are ejected into the gas phase due to bombardment of the target by e.g. ions derived from a gas (sputtering gas). The atoms ejected from the target subsequently deposit on the substrate and form the desired film.

The formation of thin films of metals and metal compounds by sputter deposition from a metal target is widely spread. Semiconductors like Si can also be deposited by sputtering. There are a number of different types of sputtering methods in use. Sputtering metal compounds and semiconductor compounds from a metal and semiconductor target respectively poses the following challenge:
In addition to the sputtering gas Argon a reactive gas has to be admitted to the sputtering chamber in order to react the metal to a metal compound. While doing so the growing film on the substrate as well as the target will react with the gas and an insulating layer will be formed at the target surface. If this has happened deposition rates in DC-sputtering (DC: direct current) will drop drastically. This mode of operation is called the poisoned mode. In addition to the low sputtering rate the poisoned mode also suffers from arcing problems. Positive charges accumulate on the insulating surface layer on the target and electrical break down occurs if the dielectric limit of the surface layer is reached. At this incident particles are ejected, which can contaminate the substrate surface.

There are a number of methods, which are used to prevent the target from getting into poisoned mode:
Applying RF-power (RF: radio frequency) to the target enables the sputter process even if the target has an insulating surface layer or even if the target is an insulator like e.g. SiO₂. However, in the case of RF-sputtering the deposition rates are relatively low making the process expensive. Furthermore, the process heat due to the plasma is relatively high so that sputtering onto temperature sensitive substrates such as plastics is not possible.

In DC and DC pulsed sputtering very careful gas flow control can be used to prevent the formation of an insulating layer on the target while still fully oxidizing the film on the substrate. Plasma Emission Monitoring (PEM) may be used to control the gas flow. This method allows to maintain a high deposition rate. Another method makes use of a dual magnetron. Two magnetron sources are powered by low frequency. In the non-sputtering cycle the electrons can reach the target and neutralize charges captured on the insulating layer, thus solving the problem with electrical break through.

Also known are plasma source enhanced processes. Sputtering methods, which do not use PEM will either result in a low deposition rate but (nearly) stoichiometric films or they will maintain a high sputtering rate but form films, which are not fully reacted. The alternative with high sputtering rate is preferred in many industrial applications. This means however, that additional equipment is required to fully react the films. A method which is wide spread is the use of a plasma source.

Prior art involves the use of a plasma source in combination with sputter deposition systems in the following configurations:
Patent US 5 849 162 provides a method of generating a plasma by means of a separate plasma generator located adjacent to the sputtering target so as to blend the plasmas created by the target and the generator into a single continuous plasma which serves both to sputter material from the target and bring about a desired chemical reaction at the substrate. The level of power, which is applied to the plasma is sufficient to reduce the pressure for the complete reaction to occur at a lower value than the threshold for poisoning of the target. The films can be reacted in the full thickness.

In patent US 6 103 320 the film deposition zone is separated from the differentially pumped reaction process zone in which the film is fully reacted. The substrates pass a number of times through deposition and reaction zones until the final film thickness is reached. The main characteristic of this process is the following one: The reactive plasma source is equipped with a grid, which prevents charged particles from impinging on the growing film on the substrate. Thus the process is especially well suited to film deposition on plastic substrates.

Patent US 5 618 388 also shows plasma sources in many different geometrical arrangements, all with the purpose of chemically reacting the sputtered metallic material.

Published application WO 2004/050944 A2 describes a method in which the sputter process is run in a sub-stoichiometric mode. The degree of oxygen deficit is kept in a predefined range by use of a lambda-probe. An interface layer (few nm) is deposited at a low deposition rate in a mode, which results in a close to stoichiometric layer, whereas the major part of the layer is deposited as a sub-stoichiometric film with a high deposition rate. The plasma source is thus again used to fully react the sputtered films, thereby reducing optical losses.

From this compilation it can be seen that so far plasma sources were used for the purpose of fully reacting non-stoichiometric metal films.

Köckert et al. (in Köckert C. et al.: "Inline sputter systems versus cluster or batch tools - Sputter coaters for optical multilayers", Optical Interference Coatings (OIC) June 27, 2004, Tucson, AZ (US), vol. ME2, June 27 2004, p. 1-3) describes an inline system for reactive Dual magnetron sputtering with several sputtering targets. Consecutive deposition steps (including reaction) are carried out in separated chambers because in each chamber a different material is deposited. Plasma Emission Monitoring (PEM) is used to obtain higher sputter rates.Gibson et al. (in Gibson D.R. et al.: "Deposition of multilayer optical coatings using closed-field magnetron sputtering", Proceedings of the Society of Photographic Instrumentation Engineers, vol.6286, August 13 2006, p.628601-1-628601-13) also teaches a process using two or more sputter targets wherein in the entire volume between said targets reactive oxidation takes place.

EP 0 328 257 A2 describes another standard process which uses several sputter stations that create sub-stoichiometric layers. The layers are oxidized in a downstream reaction zone. Again, plasma sources are only used for reacting (sub-stoichiometric) sputtered material.

### Object of the invention:

One object of the present invention is to provide a method and an apparatus for forming a thin metal compound film having stoichiometric composition and low surface roughness. Additionally, the method according to the invention should enable stable deposition conditions at a high deposition rate, in particular at a deposition rate of the same order of magnitude as for metal sputtering, and it should avoid problems with dielectric break down. Further objects and advantages in respect of the invention will appear from the following description.

### Description of the invention:

The above mentioned objective is achieved by a method according to claim 1.

The method as described above results in smoother layers characterized by reduced light scattering losses as well as high thresholds for laser damage.

The process according to the invention differs from the state of the art in that first a fully reacted (stoichiometric) layer is formed which is subsequently treated with a plasma to modify its surface. In this way, a multitude of layers may be deposited on a substrate, forming a coating. In contrast, the state of the art either teaches to form a partly oxidized (sub-stoichiometric) layer which must then be fully oxidized by a separate plasma or alternatively to form a fully oxidized (stoichiometric) layer during sputtering but no subsequent plasma treatment (since no additional oxidation is necessary). It has been found that the additional plasma treatment according to the present invention results in a substantially improved transmittance of the deposited multilayer coating.

The first constituent originates from a solid material (sputtering target / sputtering source) and is ejected into the gas phase due to bombardment of the solid material by ions derived from a gas (sputtering gas), i.e. the deposition method is reactive sputtering.

For the method according to the invention it is preferred to use DC, DC pulsed, LF-Dual-Magnetron (LF = low frequency, for example 40kHz) or RF sputtering (RF = radio frequency) or a combination thereof. In other words, the gas plasma in the deposition zone is preferably generated by means of one of the above mentioned power supplies or apparatuses.

Furthermore, it is desirable to use magnetron sputter deposition for the method according to the invention. Preferably, sputtering (during the deposition step) is effected by a magnetron sputtering device, particularly a dual-magnetron sputtering device.

The first constituent is a metal or a semiconductor preferably selected from the group consisting of: Niobium, Titanium, Tantalum, Silicon, Hafnium, Aluminum, Zirconium. Silicon (Si) is of particular interest.

According to the invention, not only one single first constituent may be used but also a combination of two or more different first constituents. If in this document it is referred to a "first constituent" the wording shall preferably encompass both, a single first constituent and alternatively a mixture of two or more (different) first constituents.

A reactive gas is a gas that reacts or is capable of reacting with the first constituent, in particular under the conditions present in the deposition zone and/or the processing zone.

The second constituent is a gas which reacts with the first constituent (therefore a reactive gas). Preferred is a gas that forms oxides, nitrides or carbides or a mixture thereof with the first constituent.

The sputtering gas is present in the deposition zone in the form of a plasma (sputtering plasma). It comprises the second constituent in gaseous form, as a reactive gas, in particular oxygen or nitrogen gas. It is preferred that the sputtering gas be a (substantially) pure reactive gas, in particular oxygen gas, or that the sputtering gas comprise (in addition to the reactive gas) an inert gas, preferably argon gas. The composition of the sputtering gas is strongly dependent on the coating rate or the power and the target material. Preferably, the reactive gas or the second constituent accounts for 10 to 75 percent (volume) of the sputtering gas.

The gas flow (i.e. the flow of the sputtering gas and/or the reactive gas and/or the inert gas) in the deposition zone (i.e. the gas flow within and/or into and/or out of the deposition zone), is monitored and controlled. In particular, it is controlled so that the formation of an insulating layer on the sputtering target is prevented and/or so that an (essentially) complete reaction of the first constituent in the layer with the second constituent is achieved, resulting in a layer of (substantially) stoichiometric metal or semiconductor compound. Monitoring is preferably effected by means of a plasma emission monitoring (PEM) device. The use of plasma emission monitoring to control the gas flow, in particular the reactive gas flow, allows to maintain a high deposition rate. In the present invention a working point is used such that stoichiometric films are deposited at a high deposition rate.

Preferably, the plasma in the deposition zone is monitored by a monitoring device (e.g. a photomultiplier). It is advantageous to use a monitoring device for each sputtering target. Normally, the monitoring device is equipped with an optical filter which is specific for the material to be detected and it is calibrated in the absence of the reactive gas. Thereby an intensity (which depends on different parameters like inert gas flow, capacity etc.) is obtained to which a value is assigned. During the deposition step a target coating intensity (i.e. a desired coating intensity) is maintained via controlling the flow of the reactive gas. The quantity of reactive gas influences the stoichiometry of the layer. However, the state not only depends on the system input (hysteresis). To arrive at the "right working point" reactive gas is added when the rate of deposition is high (i.e. when the target is still predominantly conductive) until the deposition rate changes to low (i.e. when the target is or becomes predominantly nonconductive). At this transition point from a high deposition rate to a low deposition rate the quantity of reactive gas (in respect of the flow rate) can be reduced again to increase the deposition rate. The quantity of the reactive gas can be reduced just before a transition point from a high deposition rate to a low deposition rate is reached. The closer to the transition point the higher the deposition rate. Of course, the closer one intends to move the system to the transition point, the more precisely and the faster the flow of reactive gas needs to be regulated to avoid crossing the transition point back to a low deposition rate. The preferred working point is therefore at or close to the transition point that defines or marks the beginning of the maximum drop in respect of the deposition rate. The transition point may be determined by measuring the potential difference of the respective cathode.

The method according to the invention is described as comprising a deposition step, a transfer step and a processing step. During the deposition step, a layer of a (substantially) stoichiometric metal or semiconductor compound is deposited on the substrate. Therefore, the metal or semiconductor compound layer is already (substantially) completely reacted during the deposition step. According to an alternative definition (substantially) all or at least 95, 97, 99 or 99.5 percent of the first constituent present in the layer (or at least of the part thereof that is accessible to the second constituent) has reacted with the second constituent, preferably forming a chemically stable metal or semiconductor compound that does not react further with the second constituent, in particular not under the conditions present in the deposition zone and/or the processing zone.

Preferably, no more than an additional 5, 3, 1 or 0.5 percent of the second constituent (or of any kind of second constituent) is added to the layer or substrate during the processing step (based on the amount of second constituent already present in the layer or on the substrate after the preceding deposition step and/or during the preceding transfer step and/or at the beginning of the processing step). According to an alternative definition, the amount of the second constituent present in the layer after the deposition step and/or during the subsequent transfer step and/or at the beginning of the subsequent processing step is preferably less than 5, 3, 1 or 0.5 percent below the amount of the second constituent present in a (hypothetical) perfectly stoichiometric, i.e. completely reacted, metal compound comprising the same constituents. This shall apply to the layer or at least to the part thereof that is accessible to the second constituent.

Preferably, there is a first gas plasma (sputtering plasma) in the deposition zone and a (in respect of its composition preferably different) second gas plasma (processing plasma) in the processing zone. The sputtering plasma and the processing plasma are preferably spatially separated from each other and/or generated by separate plasma sources. The transfer step is intended for transferring the substrate from the deposition zone to the processing zone.

In the processing zone no sputtering and/or (substantially) no deposition takes place. Preferably, no more than an additional 5, 3, 1 or 0.5 percent of the first constituent (or of any kind of first constituent) is added to the layer and/or to the substrate during the processing step (based on the amount of first constituent added during the preceding deposition step).

According to another embodiment no more than an additional 5,3, 1 or 0.5 percent of the second constituent (or of any kind of second constituent) is added to the layer and/or to the substrate during the processing step (based on the amount of second constituent added during the preceding deposition step).

It is preferred that the time the substrate and/or the (substantially stoichiometric) layer spends within the processing zone (i.e. from entry until exit) and/or the time it is exposed to the plasma in the processing zone amounts to at least 20, 50, 100 or 200 percent of the time the substrate and/or the layer spends within the deposition zone (i.e. from entry until exit) and/or the time it is exposed to the plasma in the deposition zone.

During the processing step and/or when the substrate is transferred out of the processing zone the layer constitutes a layer of a (substantially) stoichiometric metal or semiconductor compound as defined above.

Preferably, no more than 7, 5, 3 or 1 percent of the first constituent (or of any kind of first constituent) is removed from the layer and/or from the substrate during the processing step (based on the amount of first constituent added during the preceding deposition step). According to another embodiment, no more than 7, 5, 3 or 1 percent of the second constituent (or of any kind of second constituent) is removed from the layer and/or from the substrate during the processing step (based on the amount of second constituent added during the preceding deposition step).

According to an embodiment of the invention, the (spatially separated) deposition zone and processing zone are connected in respect of pressure and/or gas flow. Therefore, gasflow between the deposition zone and the processing zone is preferably possible. Even though gas exchange or gas flow is possible between the deposition zone and the processing zone (during the deposition step and/or the processing step), it is preferred that localized pressure differencials exist and/or that no (complete) pressure balance exists between the deposition zone and the processing zone (during the deposition step and/or the processing step). According to a preferred embodiment, the deposition zone and the processing zone are located within the same vacuum chamber.

The processing plasma in the processing zone is preferably generated by RF power and is coupled capacitively or inductively. Alternatively, other techniques of generating a plasma can be used, such as hot filament, hot cathode, ECR (electron cyclotron resonance) etc.

During the processing step the layer is exposed to and/or is brought into contact with a gas (processing gas), thereby modifying the surface of the layer. The processing gas is present in the processing zone in the form of a plasma (processing plasma). The gas in the processing zone comprises the second constituent in gaseous form comprising a reactive gas, in particular oxygen or nitrogen gas.

It is preferred that the processing gas be a (substantially) pure reactive gas, in particular oxygen gas, or that the processing gas comprise (instead of or in addition to the reactive gas) an inert gas, preferably argon gas. Preferably, the reactive gas or the second constituent accounts for 10 to 100 percent (volume) of the processing gas.

According to the invention the sputtering plasma and the processing plasma are each generated by a separate plasma source, i.e. there are at least two separate plasma sources. By using a separate plasma source in the processing zone extremely smooth layers can be achieved, which - due to their special properties - have low light scattering losses and high thresholds for laser damage. The present invention uses a plasma source during the processing step, its main purpose is however to reduce roughness of the layer. Without wanting to be bound by a theory, it is believed that this is achieved by compacting the growing layer and by etching loose particles or preferential etching of hillocks. In contrast, in methods according to the prior art plasma sources have been used to fully react layers. The invention therefore targets at reducing the surface roughness of the layers and at "compacting" the layer structure. The effect of reduction of surface roughness can be seen on single layers of metal or semiconductor compounds.

Furthermore, it is preferred that the processing zone is not equipped with a sputtering target or source adapted for the deposition of first constituent on a substrate present in the processing zone.

The process according to the invention is preferably used to build optical interference filters. Two or more different metal or semiconductor compounds (preferably comprising different first constituents and/or different second constituents) are preferably deposited which have different refractive indices, of which a first metal or semiconductor compound preferably has a low refractive index (below 1.7, preferably below 1.6) and a second metal or semiconductor compound has a high refractive index (above 1.8, preferably above 1.9). Preferably, such layers with different refractive indices are deposited alternately and/or in a repeating sequence one upon the other. This allows the construction of dielectric interference filters. The effect of reduction of stray light is best seen if at least two different layers having low and high refractive indices respectively are combined to form an optical interference coating. Using a high number of layers (more than 40) is preferred. By using the plasma of the processing zone the optical losses can nearly be eliminated, thus increasing transmittance by ca. 10 percent.

Not just for the above mentioned application, it is preferred if the process of the present invention is used to deposit a multitude of layers one upon the other on a substrate, preferably at least 20, 30 or 40 layers. Furthermore, it is preferred if there are layers with different refractive indices (as for example explained above).

The layers according to the invention preferably have each a thickness of at least 5, 8 or 10 nanometers. A coating comprising two or more layers preferably has a thickness of at least 20, 30 or 40 nanometers.

According to one embodiment of the invention, the steps (deposition step and/or transfer step and/or processing step) are carried out and/or repeated until a coating of a thickness of at least 20, 30 or 40 nanometers has been formed, wherein the coating comprises one layer or two or more adjacent layers which are deposited one upon the other.

Accordingly, the processing step is preferably carried out until the surface roughness of the layer (as measurable e.g. by an atomic force microscope) or the coating is reduced at least by a factor of 5, preferably at least by a factor of 8 or 10 and/or until the transmittance of the layer or the coating is increased by at least 5, 8 or 10 percent (compared to the surface roughness or transmittance of the layer or the coating after the preceding deposition step and/or during the preceding transfer step and/or at the beginning of the processing step or compared to the surface roughness or transmittance of a layer or a coating not having been subjected to the processing step(s)). Any method known to the skilled person may be used to determine the change in surface roughness (for example the root mean square (RMS) roughness calculation (Rq)).

It is preferred that the above described coating serving as a reference point for the reduction in roughness or increase in transmittance comprises at least 10, 20, or 40 layers and/or the (total) thickness of said coating is at least 200, 500 or 1000 nm for measuring the reduction in roughness or at least 500, 1000, 2000 or 4000 nm for measuring the improvement in transmittance. Such a (first) coating would thus preferably have the above described reduced roughness and/or increased transmittance as compared to a (second) coating which differs from the former (first) coating only in that it has not been subjected to the processing step(s) of the herein described method.

According to an embodiment of the invention at the end of the processing step the surface of the coating and/or of the topmost layer is smoother than at the beginning of the processing step.

If in this document it is referred to a "layer" the wording shall preferably encompass one of three meanings: the material / layer deposited in a single pass through the deposition zone, a single layer with final thickness or alternatively a coating comprising two or more layers deposited one upon the other. All three meanings are individually disclosed, provided that the respective meaning of the word "layer" (single layer / coating) makes sense in the context in which it is used. For example, the improvement in respect of surface roughness or transmittance may also apply to a coating, not just to a single layer. In fact, the improvement in transmittance is difficult to measure for single layers but becomes apparent when measuring a multitude of layers (i.e. coating), reaching the above mentioned 5, 8 or 10 percent for coatings with 20, 30, 40 or more layers. Accordingly, if in this document it is referred to a "first constituent" the wording shall preferably encompass the first constituent or alternatively all first constituents (individually or combined) of a layer as defined above. The same applies (correspondingly) in respect of a "second constituent". This is because, preferably, some of the layers (of a plurality of layers) comprise different first constituents and/or different second constituents compared to other layers (of the plurality of layers).
Finally, if in this document it is referred to a zone or a step (deposition zone/step, processing zone/step, transfer step) it should be noted that the layers may be deposited and/or processed within the same or alternatively within different deposition zones and/or processing zones respectively. "The deposition zone" may thus preferably denominate one single deposition zone or alternatively any one of the deposition zones or the sum of all deposition zones used. The same applies (correspondingly) to "the processing zone". A sputtering device for carrying out the herein described method could for example comprise as many different deposition zones as there are different first constituents to be deposited.

According to a preferred embodiment of the invention, the deposition step, the transfer step and the processing step are sequentially repeated, thereby generating a coating by depositing one upon the other a plurality of layers on the substrate. This is done until the desired thickness of the coating is reached, whereby the thickness of the coating is monitored, preferably optically. If different layers and/or layers with different first constituents and/or layers with different second constituents are deposited, it is preferred that they be deposited alternately and/or in a repeating sequence one upon the other. Even though the processing step may be skipped periodically, it is preferred if all of the layers making up a coating (or at least 80, 90 or 95 percent of the number of layers) have been subjected to a processing step, i.e. every deposition step is preferably followed by a processing step.

After completion of a/the processing step the substrate is transferred out of the processing zone, preferably again to a/the deposition zone until a desired (final) thickness of the coating is reached.

As another aspect of the, as defined in claim 13, there is disclosed a sputtering device characterized by a data processing unit programmed to carry out (i.e. causing the sputtering devices to carry out) the steps of the described method. The program or the instruction for carrying out said steps are also disclosed in the form of a computer program, a computer program product and a computer readable program means, preferably stored on a storage medium.

According to one embodiment an apparatus suitable for carrying out the method according to the invention comprises:
- a vacuum chamber,
- a sputtering device (preferably a dual-magnetron or pulsed DC sputtering device) capable of depositing a selected material on to a substrate,
- within the vacuum chamber a deposition zone for carrying out the deposition step of the method, in particular for depositing a (substantially) stoichiometric metal or semiconductor compound film onto the substrate,
- preferably a plasma emission monitoring device for controlling gas flow to and/or from and/or within the deposition zone, thus enabling the deposition of a stoichiometric metal or semiconductor compound film,
- within the vacuum chamber a processing zone for carrying out the processing step of the method, in particular for bringing the metal or semiconductor compound film in contact with a plasma in order to compact the structure of the growing film and/or to selectively etch parts of the films protruding out of the surface,
- an RF generator for powering a plasma within the processing zone,
- wherein the deposition zone and the processing zone are preferably spatially separated from each other but not separated with respect to vacuum pressure and gas flow,
- a transfer means for transferring the substrate between the deposition zone and the processing zone (this transfer may be repeated a number of times until the film thickness has reached the desired value),
- an optical monitoring device to monitor the thickness of the growing film on the substrate.

### Description of the drawings:

- Fig. 1: Example of an apparatus suitable for carrying out the process of the invention.
- Fig. 2: AFM measurement of a layer deposited without the use of a plasma source, Fig.2a showing a three dimensional image and Fig.2b a section analysis;
- Fig. 3: AFM measurement of a layer deposited with the use of plasma source, Fig.3a showing a three dimensional image and Fig.3b a section analysis.
- Fig. 4: Spectrophotometric measurements of layers deposited with and without the use of a plasma source.
- Fig. 5: Multilayer interference filter deposited with and without use of plasma source.

### Examples:

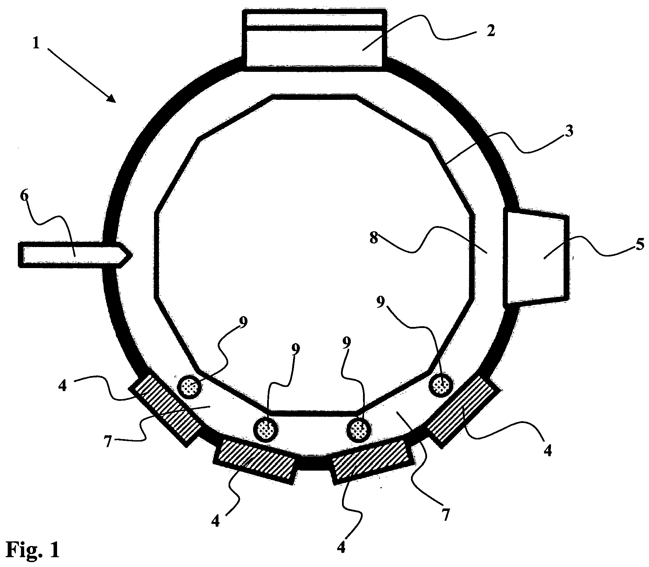

Fig. 1 shows an apparatus suitable for carrying out the method according to the invention. It comprises a vacuum chamber 1 with a vacuum valve 2, a deposition zone 7 with a number of sputter sources 4, a processing zone 8 with a plasma source 5, an optical monitoring device 6, a number of plasma emission monitoring devices 9 and transfer equipment 3 for transferring a substrate (not shown) from the deposition zone 7 to the processing zone 8. The exemplary vacuum chamber 1 shown in Fig.1 is of a roughly circular shape and the substrate is transferred between several spaced apart locations along the wall of the vacuum chamber 1. There is the deposition zone 7 with a number of sputter sources 4 which are spaced apart in the direction of movement of a substrate onto which a selected material is to be deposited. In the present example a plasma (powered by an RF generator) containing as reactive gas oxygen and metal sputter sources 4 are used. Each sputter source 4 is associated with a plasma emission monitoring device 9 which serves the purpose of controlling the gas flow within the deposition zone to prevent the formation of an insulating layer on the sputter source 4 while still allowing full oxidation of the film on the substrate. While the transfer equipment 3 transports the substrate through the deposition zone 7, the sputter sources 4 deposit a (substantially) stoichiometric metal compound film onto the substrate. The thickness of the film is measured, for example by an optical monitoring device 6 to determine whether deposition needs to be continued or not. In the processing zone 8 which is spaced apart from the deposition zone 7 in a direction of movement of the substrate the film is brought into contact with a second plasma in order to smooth the film. Without wanting to be bound to a theory it is thought that the structure of the growing film is compacted and/or parts of the film protruding out of the surface are selectively etched by the plasma. Preferably the substrate is treated with the second plasma after each crossing of the deposition zone 7. One treatment every second or third time might however also be enough to obtain a sufficiently smooth film though.

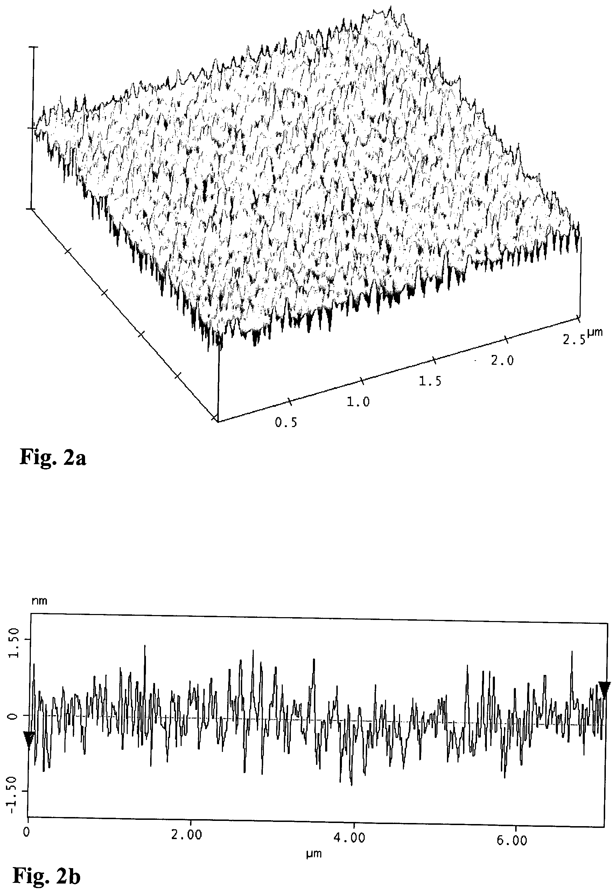

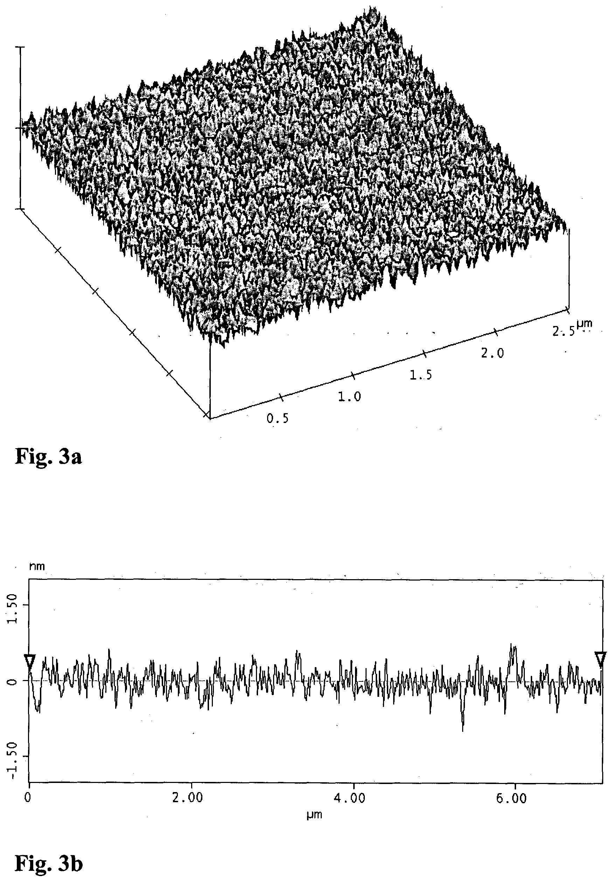

Fig. 2a/2b and Fig. 3a/3b illustrate the effect of the treatment with the second plasma in the processing zone on the structure of the film. Two measurements by an atomic force microscope (AFM) are shown. The one of Fig. 2 is of a film that has not been treated in the processing zone, while Fig.3 shows a film that has undergone treatment with the second plasma. The differences manifests in a more uniform structure of the layer of Fig. 3. Fig. 2a and 3a are three dimensional images while Fig. 2b and 3b show sections. In the example of Fig. 3 (as compared to Fig. 2) the surface roughness of a single layer of metal compound was reduced, obtaining the following results (using the root mean square (RMS) roughness calculation (Rq)): For Nb₂O₅ a reduction of surface roughness from 0.45 nm RMS to 0.23 nm RMS is measured for a layer with a thickness of 500 nm. The roughness of the uncoated substrate is 0.22 nm RMS. Thus, a layer deposited with plasma source does only induce a marginal increase of the surface roughness (0.01 nm RMS) compared to the increase of 0.23 nm RMS without use of the plasma source.

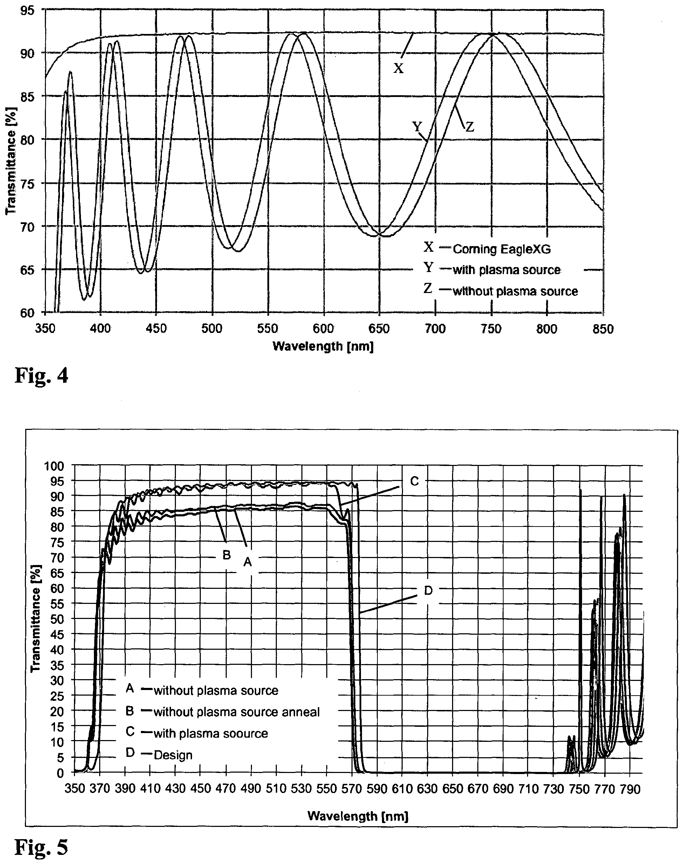

Fig. 4 depicts the results of a spectrophotometric measurements of layers deposited with and without use of the second plasma source, i.e. with and without treatment in the processing zone (the same layers as in Fig. 2 and 3 were measured in the spectrophotometer). As can be seen from the chart, the treatment results in a shift of the transmittance towards shorter wavelengths. As mentioned, the transmittance of the samples deposited with and without use of the plasma source show the same performance with the difference that the layer deposited with plasma source has a lower thickness and is therefore shifted towards shorter wavelength as compared to the curve of the layer deposited without use of plasma source. The transmittance curve of the uncoated Corning Eagle XG glass is given in Fig. 4 for comparison. As can be seen, the interference maxima of the layers reach the transmittance value of the uncoated glass, thus showing that the layers are virtually loss-free. In the wavelength range below 450 nm there is some absorption visible, however this is indicative of the absorption edge of the material. These results show that the layers are reacted/oxidized to a very high degree. This is in contrast to prior art (e.g. WO 2004/050944 A2, Fig. 6) in which layers deposited without a subsequent plasma treatment only show low transmittance of a few percent, indicating that the layers are not completely reacted/oxidized during deposition. It should be mentioned that the effect of surface smoothing for a single layer is visible in AFM but does not make a measurable difference in transmittance spectra. However, the effect becomes apparent in transmittance for multilayer interference filter systems (see Fig.5).

The results illustrated in Fig. 5 are based on a coating that was deposited as a multilayer interference filter. Again the chart shows the transmittance of a coating that was treated with the second plasma in the processing zone and an untreated coating. As can be seen from the graphs, the treatment results in a markedly increased transmittance. In the example of Fig. 5 a short pass filter consisting of 56 alternating layers of SiO₂ and Nb₂O₅ was deposited with a total thickness of 5.2 µm (micrometers). Curve C shows the filter deposited with use of the plasma source: The transmittance reaches the design values D thus indicating a loss-free coating. The filter deposited without use of the plasma source, however, only reaches a transmittance of 85% (curve A) in the pass-band region, thus indicating losses. Annealing the filter deposited without plasma source increases the transmittance only slightly (curve B). This indicates that the losses are not due to absorption caused by incomplete oxidation of the layers. The losses are attributed to surface roughness and stray light originating at the interfaces between the two film materials. This effect is not visible in a single layer as shown in Figure 4, but becomes increasingly important with increasing number of layers in the filter.

### Reference signs:

- 1: vacuum chamber
- 2: high vacuum valve
- 3: transfer equipment
- 4: sputter sources
- 5: plasma source
- 6: optical monitoring device
- 7: deposition zone
- 8: processing zone
- 9: plasma emission monitoring devices

- A: without plasma source
- B: without plasma source anneal
- C: with plasma source
- D: design

- X: corning EagleXG
- Y: with plasma source
- Z: without plasma source

## Claims

1. Method of forming a layer of a metal compound or of a semiconductor compound on a substrate, wherein the compound comprises a first and a second constituent of which the first constituent is a metal or a semiconductor and the second constituent in gaseous form is a reactive gas,
the method comprises:
- a deposition step comprising: forming on the substrate, within a deposition zone (7), the layer as a substantially stoichiometric metal or semiconductor compound by sputtering from at least one target (4) and exposing the first constituent to a gas plasma comprising the second constituent, whereby during the deposition step at least 95 percent of the first constituent present in the layer is reacted with the second constituent,
- a transfer step comprising: transferring the substrate to a processing zone (8),
- a processing step comprising: exposing the substantially stoichiometric layer, within the processing zone (8), to a gas plasma from a separate plasma source (5) the gas in the processing zone (8) comprising the second constituent, thereby modifying the surface of the layer, wherein in the processing zone (8) no deposition takes place, and
- wherein several adjacent layers are formed in this way with a total thickness of at least 20 nanometers,
- wherein the gas flow in the deposition zone (8) is monitored and controlled so that the formation of an insulating layer on the sputtering target (4) is prevented, wherefore the plasma in the deposition zone (8) is monitored by a monitoring device (9), and a working point for the gas flow is used such that stoichiometric films are deposited at a high deposition rate being of the same order of magnitude as for metal sputtering.

2. Method according to claim 1, **characterized in that**
- before the transfer step at least 98 percent of the first constituent present in the layer has reacted with the second constituent,
- the processing step is carried out until a surface roughness of the layer as measurable by an atomic force microscope is reduced at least by a factor of 8,
- that gas flow between the deposition zone (7) and the processing zone (8) is possible during the deposition step and the processing step,
- the gas plasma in the processing zone (8) comprises the second constituent in gaseous form,and
- the time the layer spends within the processing zone amounts to at least 50 percent of the time the layer spends within the preceding deposition zone (7).

3. Method according to claim 1, **characterized in that**, based on the amount of the second constituent already present in the layer at the beginning of the processing step, no more than an additional 5 percent of the second constituent is added to the layer during the processing step.

4. Method according to one of claims 1 or 3, **characterized in that** the processing step is carried out until the surface roughness of the layer as measurable by an atomic force microscope is reduced at least by a factor of 8.

5. Method according to one of claims 1 or 3 to 4, **characterized in that** the deposition zone (7) and the processing zone (8) are connected in respect of pressure and/or gas flow.

6. Method according to one of claims 1 or 3 to 5, **characterized in that** the gas plasma in the deposition zone (7) has a composition that is different from the composition of the gas plasma in the processing zone (8).

7. Method according to one of claims 1 or 3 to 6, **characterized in that** the time the layer spends within the processing zone (8) or the duration of the processing step amounts to at least 50 percent of the time the layer spends within the preceding deposition zone (7) or of the duration of the preceding deposition step.

8. Method according to one of claims 1 or 3 to 7, **characterized in that** the thickness of the coating is monitored, preferably by means of an optical monitoring device (6).

9. Method according to one of claims 1 or 3 to 8, **characterized in that** several adjacent layers are formed and that some of the said layers comprise different first constituents and/ or second constituents compared to others of the said layers.

10. Method according to one of claims 1 or 3 to 9, **characterized in that** the gas flow in the deposition zone (7) is monitored and controlled, wherein monitoring is effected by means of a plasma emission monitoring device (9).

11. Method according to one of claims 1 or 3 to 10, **characterized in that** the gas plasma in the processing zone (8) is generated by means of an RF generator.

12. Method according to one of claims 1 or 3 to 11 **characterized in that** sputtering is effected by a dual-magnetron or pulsed DC sputtering device.

13. Sputtering device, **characterized by** a data processing unit programmed to carry out the steps of the method according to one of claims 1 to 12.

## Patentansprüche

1. Verfahren zur Bildung einer Schicht aus einer Metallverbindung oder aus einer Halbleiterverbindung auf einem Substrat, wobei die Verbindung einen ersten und einen zweiten Bestandteil umfasst, von denen der erste Bestandteil ein Metall oder ein Halbleiter und die zweite Verbindung, in Gasform, ein Reaktivgas ist,
das Verfahren umfasst:
- einen Beschichtungsschritt umfassend: Die Bildung der Schicht auf dem Substrat in einer Beschichtungszone, als eine im Wesentlichen stöchiometrische Metall-oder Halbleiterverbindung durch Sputtern vom zumindest einem Target (4) und das Aussetzen des ersten Bestandteils einem Gasplasma, das den zweiten Bestandteil umfasst, wodurch während des Beschichtungsprozesses zumindest 95% des ersten in der Schicht vorhandenen Bestandteils mit dem zweiten Bestandteil zur Reaktion gebracht wird,
- einen Transferschritt umfassend: Den Transfer des Substrats in die Beschichtungszone (8),
- einen Behandlungsschritt umfassend: Das Aussetzen der im Wesentlichen stöchiometrischen Schicht einem Gasplasma einer eigenen Plasmaquelle (5) innerhalb der Behandlungszone (8), wobei das Gas in der Behandlungszone den zweiten Bestandteil umfasst, damit die Oberfläche der Schicht modifiziert wird und in der Behandlungszone keine Beschichtung stattfindet und
- wobei mehrere aneinandergrenzende Schichten auf diese Weise mit einer Gesamtschichtdicke von zumindest 20nm gebildet werden,
- wobei der Gasfluss in der Beschichtungszone überwacht und gesteuert wird, so dass die Bildung einer isolierenden Schicht auf dem Target verhindert wird, wofür das Plasma in der Beschichtungszone durch eine Überwachungsvorrichtung (9) überwacht wird und ein Arbeitspunkt für den Gasfluss verwendet wird, so dass stöchiometrische Schichten mit einer hohen Beschichtungsrate, in derselben Grössenordnung wie für metallisches Sputtern, abgeschieden werden.

2. Verfahren nach Anspruch 1, **dadurch gekennzeichnet, dass**
- vor dem Transferschritt zumindest 98 Prozent des ersten Bestandteils in der Schicht mit dem zweiten Bestandteil reagiert haben,
- der Behandlungsschritt so lange durchgeführt wird, bis die durch Atomkraft-Mikroskopie bestimmte Oberflächenrauigkeit der Schicht zumindest um den Faktor 8 verringert ist,
- ein Gasfluss zwischen der Beschichtungszone (7) und der Behandlungszone (8) während des Beschichtungs- und des Behandlungsschrittes möglich ist,
- das Gasplasma in der Behandlungszone (8) den zweiten Bestandteil in gasförmiger Weise umfasst, und
- die Zeit, die die Schicht innerhalb der Behandlungszone verbringt, mindestens 50 Prozent der Zeit entspricht, die die Schicht in der vorhergehenden Beschichtungszone (7) verbracht hat.

3. Verfahren nach Anspruch 1, **dadurch gekennzeichnet, dass** beruhend auf dem Anteil des zweiten Bestandteils der bereits in der Schicht am Anfang des Behandlungsschrittes vorhanden ist, nicht mehr als 5 Prozent des zweiten Bestandteils während des Behandlungsschrittes hinzugefügt werden.

4. Verfahren nach einem der Ansprüche 1 oder 3, **dadurch gekennzeichnet, dass** der Behandlungsschritt so lange durchgeführt wird, bis die durch Atomkraft-Mikroskopie bestimmte Oberflächenrauigkeit der Schicht zumindest um den Faktor 8 verringert ist.

5. Verfahren nach einem der Ansprüche 1 oder 3 bis 4, **dadurch gekennzeichnet, dass** ein die Beschichtungszone (7) und die Behandlungszone (8) bezüglich des Drucks und/oder des Gasfluss verbunden sind.

6. Verfahren nach einem der Ansprüche 1 oder 3 bis 5, **dadurch gekennzeichnet, dass** das Gasplasma in der Beschichtungszone (7) eine Zusammensetzung aufweist, die unterschiedlich von der Zusammensetzung des Gasplasmas in der Behandlungszone (8) ist.

7. Verfahren nach einem der Ansprüche 1 oder 3 bis 6, **dadurch gekennzeichnet, dass** die Zeit, die die Schicht in der Behandlungszone (8) verbringt oder die Dauer des Behandlungsschrittes zumindest 50 Prozent der Zeit entspricht, die die Schicht in der Beschichtungszone (7) verbringt oder die der Dauer des vorhergehenden Beschichtungsschrittes entspricht.

8. Verfahren nach einem der Ansprüche 1 oder 3 bis 7, **dadurch gekennzeichnet, dass** die Dicke der Beschichtung überwacht wird, bevorzugt durch ein optisches Überwachungsgerät (6).

9. Verfahren nach einem der Ansprüche 1 oder 3 bis 8, **dadurch gekennzeichnet, dass** mehrere aneinandergrenzende Schichten gebildet werden und dass einige der besagten Schichten, im Vergleich zu anderen Schichten, unterschiedliche erste Bestandteile und/oder zweite Bestandteile aufweisen.

10. Verfahren nach einem der Ansprüche 1 oder 3 bis 9, **dadurch gekennzeichnet, dass** der Gasfluss in der Beschichtungszone (7) überwacht und gesteuert wird, wobei die Überwachung mittels eines Plasmaemissionsmonitorgeräts (9) durchgeführt wird.

11. Verfahren nach einem der Ansprüche 1 oder 3 bis 10, **dadurch gekennzeichnet, dass** das Gasplasma in der Behandlungszone (8) durch einen RF-Generator erzeugt wird.

12. Verfahren nach einem der Ansprüche 1 oder 3 bis 11, **dadurch gekennzeichnet, dass** das Sputtern durch ein Dual-Magnetron oder durch eine gepulste Sputtervorrichtung bewirkt wird.

13. Sputtervorrichtung, **gekennzeichnet durch** eine Datenverarbeitungseinheit, die zur Durchführung der Schritte des Verfahrens nach einem der Ansprüche 1 bis 12 programmiert ist.

## Revendications

1. Procédé pour former une couche d'un composé de métal ou d'un composé semi-conducteur sur un substrat, le composé comprenant un premier et un deuxième constituant dont le premier constituant est un métal ou un semi-conducteur et le deuxième constituant, sous forme gazeuse, est un gaz réactif,
le procédé comprenant :
- une étape de dépôt consistant à former sur le substrat, dans une zone de dépôt (7), une couche d'un composé de métal ou semi-conducteur sensiblement stœchiométrique par pulvérisation à partir d'au moins une cible (4), et à exposer le premier constituant à un plasma gazeux comprenant le deuxième constituant, pendant l'étape de dépôt, au moins 95 pour cent du premier constituant présent dans la couche réagissant avec le deuxième constituant,
- une étape de transfert consistant à transférer le substrat vers une zone de traitement (8),
- une étape de traitement consistant à exposer la couche sensiblement stœchiométrique, dans la zone de traitement (8), à un plasma gazeux provenant d'une source plasma séparée (5), le gaz dans la zone de traitement (8) comprenant le deuxième constituant, modifiant ainsi la surface de la couche, aucun dépôt n'ayant lieu dans la zone de traitement (8), et
dans lequel plusieurs couches adjacentes sont formées de cette façon avec une épaisseur totale d'au moins 20 nanomètres,
- dans lequel l'écoulement de gaz dans la zone de dépôt (8) est surveillé et contrôlé de façon à empêcher la formation d'une couche isolante sur la cible de pulvérisation (4), le plasma dans la zone de dépôt (8) étant de ce fait contrôlé par un dispositif de contrôle (9) et un point de service l'écoulement de gaz étant utilisé de sorte que des films stœchiométriques sont déposés à une vitesse de dépôt élevée, du même ordre de grandeur que pour la pulvérisation de métal.

2. Procédé selon la revendication 1, **caractérisé en ce que**
- avant l'étape de transfert, au moins 98 pour cent du premier constituant présent dans la couche a réagi avec le deuxième constituant,
- l'étape de traitement est réalisée jusqu'à ce que la rugosité de surface de la couche, telle que mesurable par un microscope à force atomique, soit réduite d'au moins un facteur 8,
- l'écoulement de gaz entre la zone de dépôt (7) et la zone de traitement (8) est possible pendant l'étape de dépôt et l'étape de traitement,
- le plasma gazeux dans la zone de traitement (8) comprend le deuxième constituant sous forme gazeuse, et
- le temps passé par la couche dans la zone de traitement est égal à au moins 50 pour cent du temps passé par la couche dans la zone de dépôt (7) précédente.

3. Procédé selon la revendication 1, **caractérisé en ce que**, sur la base de la quantité du deuxième constituant déjà présent dans la couche au début de l'étape de traitement, il n'est pas ajouté plus de 5 pour cent supplémentaires du deuxième constituant à la couche pendant l'étape de traitement.

4. Procédé selon l'une des revendications 1 ou 3, **caractérisé en ce que** l'étape de traitement est réalisée jusqu'à ce que la rugosité de surface de la couche, telle que mesurable par un microscope à force atomique, soit réduite d'au moins un facteur 8.

5. Procédé selon l'une des revendications 1 ou 3 à 4, **caractérisé en ce que** la zone de dépôt (7) et la zone de traitement (8) sont connectées en ce qui concerne la pression et/ou le débit de gaz.

6. Procédé selon l'une des revendications 1 ou 3 à 5, **caractérisé en ce que** le plasma gazeux dans la zone de dépôt (7) a une composition qui est différente de la composition du plasma gazeux dans la zone de traitement (8).

7. Procédé selon l'une des revendications 1 ou 3 à 6, **caractérisé en ce que** le temps passé par la couche dans la zone de traitement (8) ou bien la durée de l'étape de traitement est égal(e) à au moins 50 pour cent du temps passé par la couche dans la zone de dépôt (7) précédente ou de la durée de l'étape de dépôt précédente.

8. Procédé selon l'une des revendications 1 ou 3 à 7, **caractérisé en ce que** l'épaisseur du revêtement est contrôlée, de préférence par le biais d'un dispositif de contrôle optique (6).

9. Procédé selon l'une des revendications 1 ou 3 à 8, **caractérisé en ce que** plusieurs couches adjacentes sont formées et **en ce que** certaines desdites couches comprennent des premiers et/ou des deuxièmes constituants différents par rapport à d'autres desdites couches.

10. Procédé selon l'une des revendications 1 ou 3 à 9, **caractérisé en ce que** l'écoulement de gaz dans la zone de dépôt (7) est surveillé et contrôlé, le contrôle étant effectué par le biais d'un dispositif de contrôle à émission de plasma (9).

11. Procédé selon l'une des revendications 1 ou 3 à 10, **caractérisé en ce que** le plasma gazeux dans la zone de traitement (8) est généré par le biais d'un générateur RF.

12. Procédé selon l'une des revendications 1 ou 3 à 11, **caractérisé en ce que** la pulvérisation est effectuée par un dispositif de pulvérisation à double magnétron ou DC pulsé.

13. Dispositif de pulvérisation, **caractérisé par** une unité de traitement des données programmée pour réaliser les étapes du procédé selon l'une des revendications 1 à 12.
